# EUROPEAN PATENT APPLICATION

(11) **EP 0 588 577 A2**
(43) Date of publication of application: **23.03.1994**
(21) Application number: 93307184.7
(22) Date of filing: 13.09.1993
(51) Int. Cl.: H01L 23/485

(54) **Hermetically sealed integrated circuits**

(30) Priority: 14.09.1992 US 944574
(71) Applicant: DOW CORNING CORPORATION, Midland Michigan 48686-0994 (US)
(72) Inventor: Kilby, Jack S., Dallas, Texas (US)
(74) Representative: Laredo, Jack Joseph

(57) **Abstract**

The present invention provides hermetically sealed integrated circuits which can have a standardized arrangement of external contacts. These circuits comprise a circuit subassembly (1) having external contacts (2). Onto the surface of the subassembly surrounding the external contacts is formed a first ceramic passivating layer (3). Next, a non-corroding, conductive layer (4) is formed on the external contacts and portions of the first ceramic passivating layer. Then a second ceramic passivating layer (6) is formed on the non-corroding, conductive layer and that portion of the first passivating layer not covered by the non-corroding, conductive layer. Finally, the second passivating layer is etched through to the conductive layer to allow external contact with the circuit. The present invention also relates to methods for producing the above integrated circuits.

## Description

Modern electronic devices have required the production of large numbers of integrated circuits. Current production methods, however, have several deficiencies. First, the circuits are designed and produced in a wide variety of configurations having numerous patterns of external contacts (bond pads) on the surface of the circuit (terminal patterns). Because of variability in contact patterns, a universal approach to mounting the circuit for simplified testing and burn-in of the integrated circuits has been difficult. Secondly, the circuits are easily damaged by exposure to a broad range of environmental conditions such as moisture, ions, heat and abrasion. A significant amount of work has been directed toward various protective measures to minimize the exposure of such circuits to the above conditions and to thereby increase their performance, reliability and life.

One prior art approach to protecting integrated circuits has involved sealing or encapsulating the circuits after interconnection with a package or circuit board. For example, it is known in the art to use protective layers of silicones, polyimides, epoxies, other organics and plastics. Such materials, however, are of limited value since most are permeable to environmental moisture and ions. Similarly, interconnected circuits have also been sealed within ceramic packages. This process is relatively effective in increasing device reliability and is currently used in select applications. The added size, weight and cost involved in this method, however, inhibits widespread application in the electronic industry.

The use of lightweight ceramic protective coatings on electronic devices has also been suggested. For instance, U.S. Patent Nos. 4,756,977 and 4,749,631 describe the use of ceramic silica coatings derived from hydrogen silsesquioxane and silicate esters, respectively, as well as additional ceramic layers for hermetic barriers. The present inventors have found that when such coatings are applied specifically to integrated circuits during the wafer stage and even though the external contacts are subsequently opened by removing a portion of the coating, the resultant circuits remain hermetically sealed and exhibit increased reliability and life.

Protection of circuits at the wafer stage is also known in the art. For example, it is known to coat fabricated integrated circuits with ceramic materials such as silica and/or silicon nitride by chemical vapor deposition (CVD) techniques. These coatings are then etched to open the contacts for the application of leads. The wafers coated in this manner, however, have inadequate reliability and life.

The present inventors have now solved the above problems associated with uniformity and hermeticity of integrated circuits by (1) sealing the original external contacts of the circuit with a non-corroding, conductive layer, (2) using this non-corroding, conductive layer to relocate the external contacts of the circuit to thereby form a standardized arrangement of external contacts and (3) sealing the remainder of the circuit surface with ceramic passivation coatings.

The present invention provides hermetically sealed integrated circuits which can have a standardized arrangement of external contacts. These circuits comprise a circuit subassembly having external contacts. Onto the surface of the subassembly surrounding the external contacts is formed a first ceramic passivating layer. Next, a non-corroding, conductive layer is formed on the external contacts and portions of the first ceramic passivating layer. Then a second ceramic passivating layer is formed on the non-corroding, conductive layer and that portion of the first passivating layer not covered by the non-corroding, conductive layer. Finally, the second passivating layer is etched through to the conductive layer to allow external contact with the circuit. The present invention also relates to methods for producing the above integrated circuits.

The present invention is based on our finding that integrated circuits can be minimally packaged into devices which afford a standardized arrangement of external contacts and which are hermetically sealed from the environment. This standardized approach is beneficial in that the costs associated with testing and burn-in are reduced by a simplified, uniform process. Similarly, the hermeticity of these circuits is beneficial in that they have increased reliability and performance. In addition, since this process is generally performed at the wafer stage, production can be simplified and, thus, costs reduced.

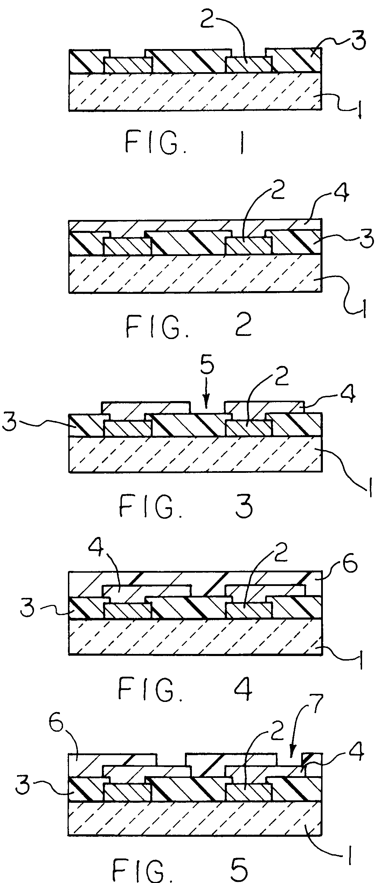

The integrated circuit subassemblies used in the process of this invention are not critical and any which are known in the art and/or produced commercially are useful herein. The processes used to produce such circuits are well known and not critical to the invention. Exemplary of such circuits are those comprising a semiconductor substrate (eg., silicon, gallium arsenide and the like) having an epitaxial layer grown thereon. This epitaxial layer is appropriately doped to form the PN-junction regions which constitute the active regions of the device. These active regions are diodes and transistors which form the integrated circuit when appropriately interconnected by properly patterned metallic layers. These metallic interconnect layers terminate at external contacts on the exterior surface of the circuit subassembly. Such a device is shown in Figure 1 wherein (1) is the wafer circuitry and (2) is the contact.

According to the present invention, a first layer of passivation is formed on the exterior surface of the circuit surrounding the external contacts to provide mechanical protection and a hermetic barrier. This layer is represented by (3) in Figure 1. The process used to form this layer generally comprises forming one or more passivating coatings on the entire surface of the circuit (first layer of passivation) followed by etching the coatings to expose the external contacts.

The material used for this first passivation layer is not critical as long as it forms the desired hermetic and dielectric barrier and it can be applied at a temperature which doesn't damage the circuit. Generally this passivation layer comprises one or more coatings of ceramic material. Preferably, the ceramic material is a silicon-containing ceramic such as a silicon oxide, silicon nitride, silicon oxynitride, amorphous silicon carbide, silicon oxycarbide, silicon carbonitride, silicon oxycarbonitride, amorphous silicon, diamond like coatings or a combination of the above.

The method of forming such ceramic passivation coatings is likewise not critical as long as it doesn't damage the circuit and can include techniques known in the ceramic coating art such as CVD or solution deposition techniques. If CVD techniques are used, the materials and methods for the formation of these ceramic coatings are not critical to the invention and many are known in the art. Examples of applicable methods include thermal vapor deposition, photothermal vapor deposition, plasma enhanced chemical vapor deposition (PECVD), electron cyclotron resonance (ECR), jet vapor deposition or any similar technique. These processes involve the addition of energy (in the form of heat, plasma and the like) to the vaporized species to cause the desired reaction and deposition.

In thermal vapor deposition, the coating is deposited by passing a stream of the desired precursor gases over a heated substrate. When the precursor gases contact the hot surface, they react and deposit the coating. Substrate temperatures in the range of 100-1000°C. are sufficient to form these coatings in several minutes to several hours, depending on the precursors and the thickness of the coating desired. If desired, reactive metals can be used in such a process to facilitate deposition.

In PECVD, the desired precursor gases are reacted by passing them through a plasma field. The reactive species thereby formed are then focused at the substrate and readily adhere. Generally, the advantage of this process over thermal CVD is that lower substrate temperature can be used. For instance, substrate temperatures of 20 to 600°C. are functional.

The plasma used in such processes can comprise energy derived from a variety of sources such as electric discharges, electromagnetic fields in the radio frequency or microwave range, lasers or particle beams. Generally preferred in most plasma deposition processes is the use of radio frequency (10 kHz to 10² MHz) or microwave (0.1-10 GHz) energy at moderate power densities (0.1-5 watts/cm²). The specific frequency, power and pressure, however, are generally tailored to the precursor gases and the equipment used.

Examples of suitable processes for the deposition of the amorphous silicon containing coating include (a) CVD of a silane, halosilane, halodisilane, halopolysilane or mixtures thereof, (b) the PECVD of a silane, halosilane, halodisilane, halopolysilane or mixtures thereof or (c) the metal assisted chemical vapor deposition (MACVD) of a silane, halosilane, halodisilane, halopolysilane or mixtures thereof.

Examples of suitable processes for the deposition of the silicon carbon containing coating include (1) CVD of a silane, alkylsilane, halosilane, halodisilane, halopolysilane or mixtures thereof in the presence of a hydrocarbon of one to six carbon atoms or an alkylsilane, (2) PECVD of a silane, alkylsilane, halosilane, halodisilane, halopolysilane or mixtures thereof in the presence of a hydrocarbon of one to six carbon atoms or an alkylsilane or (3) PECVD of a silacyclobutane or disilacyclobutane as further described in U.S. Patent No. 5,011,706.

Examples of suitable processes for the deposition of the silicon oxygen carbon containing coating include (1) CVD of a silane, alkylsilane, halosilane, halodisilane, halopolysilane or mixtures thereof in the presence of a hydrocarbon of one to six carbon atoms or an alkylsilane and further in the presence of an oxidizing gas such as air, oxygen, ozone, nitrous oxide and the like, (2) PECVD of a silane, alkylsilane, halosilane, halodisilane, halopolysilane or mixtures thereof in the presence of a hydrocarbon of one to six carbon atoms or an alkylsilane and further in the presence of an oxidizing gas such as air, oxygen, ozone, nitrous oxide and the like or (3) PECVD of a silacyclobutane or disilacyclobutane as further described in U.S. Patent No. 5,011,706, in the presence of an oxidizing gas such as air, oxygen, ozone, nitrous oxide and the like.

Examples of suitable processes for the deposition of the silicon nitrogen containing coating include (A) CVD of a silane, halosilane, halodisilane, halopolysilane or mixtures thereof in the presence of ammonia, (B) PECVD of a silane, halosilane, halodisilane, halopolysilane or mixtures thereof in the presence of ammonia, (C) PECVD of a SiH₄ - N₂ mixture such as that described by Ionic Systems or Katoh et al. in the Japanese Journal of Applied Physics, vol. 22, #5, pp 1321-1323 or (D) reactive sputtering such as that described in Semiconductor International, p 34, August 1987.

Examples of suitable processes for the deposition of the silicon oxygen nitrogen containing coating include (A) CVD of a silane, halosilane, halodisilane, halopolysilane or mixtures thereof in the presence of ammonia and an oxidizing gas such as air, oxygen, ozone, nitrous oxide and the like, (B) PECVD of a silane, halosilane, halodisilane, halopolysilane or mixtures thereof in the presence of ammonia and an oxidizing gas such as air, oxygen, ozone, nitrous oxide and the like, (C) PECVD of a SiH₄ - N₂ mixture such as that described by Ionic Systems or Katoh et al. in the Japanese Journal of Applied Physics, vol. 22, #5, pp 1321-1323 in the presence of an oxidizing gas such as air, oxygen, ozone, nitrous oxide and the like or (D) reactive sputtering such as that described in Semiconductor International, p 34, August 1987 in the presence of an oxidizing gas such as air, oxygen, ozone, nitrous oxide and the like.

Examples of suitable processes for the deposition of the silicon oxygen containing coating include (A) CVD of a silane, halosilane, halodisilane, halopolysilane or mixtures thereof in the presence of an oxidizing gas such as air, oxygen, ozone, nitrous oxide and the like, (B) PECVD of a silane, halosilane, halodisilane, halopolysilane or mixtures thereof in the presence of an oxidizing gas such as air, oxygen, ozone, nitrous oxide and the like, (c) CVD or PECVD of tetraethylorthosilicate, methyltrimethoxysilane, dimethyldimethoxysilane, methylhydrogensiloxane, dimethylsiloxane or the like in the presence of an oxidizing gas such as air, oxygen, ozone, nitrous oxide and the like or (d) CVD or PECVD of hydrogen silsesquioxane resin in the presence of an oxidizing gas such as air, oxygen, ozone, nitrous oxide and the like as described in US Patent No. 5,165,955.

Examples of suitable processes for the deposition of the silicon carbon nitrogen containing coating include (i) CVD of hexamethyldisilazane, (ii) PECVD of hexamethyldisilazane, (iii) CVD of silane, alkylsilane, halosilane, halodisilane, halopolysilane or mixture thereof in the presence of a hydrocarbon of one to six carbon atoms or an alkylsilane and further in the presence of ammonia or (iv) PECVD of a silane, alkylsilane, halosilane, halodisilane, halopolysilane or mixture thereof in the presence of a hydrocarbon of one to six carbon atoms or an alkylsilane and further in the presence of ammonia.

Examples of suitable processes for the deposition of the silicon oxygen carbon nitrogen containing coating include (i) CVD of hexamethyldisilazane in the presence of an oxidizing gas such as air, oxygen, ozone, nitrous oxide and the like, (ii) PECVD of hexamethyldisilazane in the presence of an oxidizing gas such as air, oxygen, ozone, nitrous oxide and the like, (iii) CVD of silane, alkylsilane, halosilane, halodisilane, halopolysilane or mixture thereof in the presence of a hydrocarbon of one to six carbon atoms or an alkylsilane and further in the presence of ammonia and an oxidizing gas such as air, oxygen, ozone, nitrous oxide and the like or (iv) PECVD of a silane, alkylsilane, halosilane, halodisilane, halopolysilane or mixture thereof in the presence of a hydrocarbon of one to six carbon atoms or an alkylsilane and further in the presence of ammonia and an oxidizing gas such as air oxygen, ozone, nitrous oxide and the like.

Examples of suitable processes for the deposition of A diamond-like carbon coating include exposing the substrate to an argon beam containing a hydrocarbon in the manner described in NASA Tech Briefs, November 1989 or by one of the methods described by Spear in J. Am. Ceram. Soc., 72, 171-191 (1989).

If a solution deposition technique is used, the process comprises coating the circuit with a composition comprising a preceramic silicon-containing material followed by converting the preceramic silicon-containing material to a ceramic. The preceramic material is then converted to a ceramic by heating it to a sufficient temperature.

As used in the present invention, the term "preceramic silicon-containing material" describes material which can be rendered sufficiently flowable to impregnate and coat the surface of a circuit and which can be subsequently converted to a solid layer exhibiting properties generally recognized by those skilled in the art as characteristic of a ceramic. These materials include, for example, precursors to silicon oxides, silicon nitride, silicon oxynitride, silicon oxycarbide, silicon carbonitride, silicon oxycarbonitride, silicon carbide and the like.

The preferred preceramic compounds to be used in the process of this invention are precursors to silicon oxides, especially silica. The silica precursors which may be used in the invention include, but are not limited to, hydrogen silsesquioxane resin (H-resin), hydrolyzed or partially hydrolyzed RₙSi(OR)₄₋ₙ or combinations of the above, in which each R is independently an aliphatic, alicyclic or aromatic substituent of 1-20 carbon atoms, preferably 1-4, such as an alkyl (eg. methyl, ethyl, propyl), alkenyl (eg. vinyl or allyl), alkynyl (eg. ethynyl), cyclopentyl, cyclohexyl and phenyl and n is 0-3, preferably 0 or 1.

H-resin is used herein to describe a variety of hydridosilane resins having units of the structure HSi(OH)ₓ(OR)_{y}O_{z/2} in which each R is independently an organic group which, when bonded to silicon through the oxygen atom, forms a hydrolyzable substituent, x = 0-2, y = 0-2, z = 1-3 and x + y + z = 3. These resins may be either fully condensed (x = 0, y = 0 and z = 3) or they may be only partially hydrolyzed (y does not equal 0 over all the units of the polymer) and/or partially condensed (x does not equal 0 over all the units of the polymer). Although not represented by this structure, various units of these resins may have either zero or more than one Si-H bond due to various factors involved in their formation and handling. Exemplary of substantially condensed H-resins (less than about 300 ppm silanol) are those formed by the process of U. S. Patent No. 3,615,272. This polymeric material has units of the formula (HSiO_{3/2})ₙ in which n is generally 8-1000. The preferred resin has a number average molecular weight of from about 800-2900 and a weight average molecular weight of between about 8000-28,000 (obtained by GPC analysis using polydimethylsiloxane as a calibration standard). When heated sufficiently, this material yields a ceramic coating essentially free of SiH bonds.

Exemplary H-resin which may not be fully condensed include those of U.S. Patent No. 5,010,159 or U.S. Patent No. 4,999,397. Exemplary H-resin which is not fully hydrolyzed or condensed is that formed by a process which comprises hydrolyzing a hydrocarbonoxy hydridosilane with water in an acidified oxygen-containing polar organic solvent.

A platinum, rhodium or copper catalyst may be admixed with the H-resin to increase the rate and extent of its conversion to silica. Any platinum, rhodium or copper compound or complex that can be solubilized in this solution will be operable. For instance, an organoplatinum composition such as platinum acetylacetonate or rhodium catalyst RhCl₃[S(CH₂CH₂CH₂CH₃)₂]₃, obtained from Dow Corning Corporation, Midland, Michigan, are all within the scope of this invention. The above catalysts are generally added to the solution in an amount of between about 5 and 500 ppm platinum or rhodium based on the weight of resin.

The second type of silica precursor material useful herein includes hydrolyzed or partially hydrolyzed compounds of the formula RₙSi(OR)₄₋ₙ in which R and n are as defined above. Some of these materials are commercially available, for example, under the tradename ACCUGLASS. Specific compounds of this type include methyltriethoxysilane, phenyltriethoxysilane, diethyldiethoxysilane, methyltrimethoxysilane, dimethyldimethoxysilane, phenyltrimethoxysilane, vinyltrimethoxysilane, tetramethoxysilane, tetraethoxysilane, tetrapropoxysilane and tetrabutoxysilane. After hydrolysis or partial hydrolysis of these compounds, the silicon atoms therein may be bonded to C, OH or OR groups, but a substantial portion of the material is believed to be condensed in the form of soluble Si-O-Si resins. Compounds in which n = 2 or 3 are generally not used alone as volatile cyclic structures are generated during pyrolysis, but small amounts of said compounds may be cohydrolyzed with other silanes to prepare useful preceramic materials.

In addition to the above SiO₂ precursors. other ceramic oxide precursors may also be advantageously used herein either solely or in combination with the above SiO₂ precursors. The ceramic oxide precursors specifically contemplated herein include compounds of various metals such as aluminum, titanium, zirconium, tantalum, niobium and/or vanadium as well as various non-metallic compounds such as those of boron or phosphorous which may be dissolved in solution, hydrolyzed and subsequently pyrolyzed at relatively low temperatures to form ceramic oxides.

The above ceramic oxide precursor compounds generally have one or more hydrolyzable groups bonded to the above metal or non-metal, depending on the valence of the metal. The number of hydrolyzable groups to be included in these compounds is not critical as long as the compound is soluble in the solvent. Likewise, selection of the exact hydrolyzable substituent is not critical since the substituents are either hydrolyzed or pyrolyzed out of the system. Typical hydrolyzable groups include, but are not limited to, alkoxy, such as methoxy, propoxy, butoxy and hexoxy, acyloxy, such as acetoxy, other organic groups bonded to said metal or non-metal through an oxygen such as acetylacetonate or amino groups. Specific compounds, therefore, include zirconium tetracetylacetonate, titanium dibutoxy diacetylacetonate, aluminum triacetylacetonate, tetraisobutoxy titanium and Ti(N(CH₃)₂)₄.

When SiO₂ is to be combined with one of the above ceramic oxide precursors, generally it is used in an amount such that the final ceramic contains 70 to 99.9 percent by weight SiO₂.

Examples of suitable silicon carbonitride precursors include hydridopolysilazane (HPZ) resin and methylpolydisilylazane (MPDZ) resin. Processes for the production of these materials are described in U.S. Patent Nos. 4,540,803 and 4,340,619, respectively. Examples of silicon carbide precursors include polycarbosilanes and examples of silicon nitride precursors include polysilazanes. Oxygen can be incorporated into the ceramics resulting from the above precursors by pyrolyzing them in an oxygen-containing environment.

The above preceramic material is then used to coat the integrated circuit. The material can be used in any practical form, but it is preferred to use a solution comprising the preceramic material in a suitable solvent. If this solution approach is used, the preceramic solution is generally formed by simply dissolving or suspending the preceramic material in a solvent or mixture of solvents. Various facilitating measures such as stirring and/or heat may be used to assist in the dissolution. The solvents which may be used in this method include, for example, alcohols such as ethyl or isopropyl, aromatic hydrocarbons such as benzene or toluene, alkanes such as n-heptane or dodecane, ketones, cyclic dimethylpolysiloxanes, esters or glycol ethers, in an amount sufficient to dissolve the above materials to low solids. For instance, enough of the above solvent can be included to form a 0.1-85 weight percent solution.

The circuit is then coated with this solution by means such as spin, spray, dip or flow coating and the solvent is allowed to evaporate. Any suitable means of evaporation such as simple air drying by exposure to an ambient environment or the application of a vacuum may be used.

Although the above described methods primarily focus on using a solution approach, one skilled in the art would recognize that other equivalent means (eg., melt impregnation) would also function herein and are contemplated to be within the scope of this invention.

The preceramic material is then typically converted to the silicon-containing ceramic by heating it to a sufficient temperature. Generally, this temperature is in the range of 50 to 800°C. depending on the pyrolysis atmosphere and the preceramic compound. Preferred temperatures are in the range of 50 to 600°C. and more preferably 50-400°C. Heating is generally conducted for a time sufficient to ceramify, generally up to 6 hours, with less than 2 hours being preferred.

The above heating may be conducted at any effective atmospheric pressure from vacuum to superatmospheric and under any effective oxidizing or non-oxidizing gaseous environment such as those comprising air, O₂, an inert gas (N₂, etc.), ammonia, amines, moisture, N₂O and the like.

Any method of heating such as the use of a convection oven, rapid thermal processing, hot plate or radiant or microwave energy is generally functional herein. The rate of heating, moreover, is also not critical, but it is most practical and preferred to heat as rapidly as possible.

By the process of the invention, therefore, one or more ceramic coatings are used to form the first layer of passivation. This first passivation is then etched or partially etched at the contacts to allow further processing of the chip as described hereinafter. The method of etching is not critical and nearly any process known in the art will function herein. This includes, for example, dry etching (eg., with plasma), wet etching (eg., with aqueous hydrofluoric acid) and/or laser ablation.

It should be noted that conventional commercial integrated circuits often have the above first layer passivation/open external contact arrangement formed by a CVD process. It is contemplated that such circuits can be used in this invention and processed as hereinafter set forth.

The above circuits with a first layer passivation and open external contacts are next processed by (1) forming a non-corroding, conductive layer over the external contacts and portions of the first passivation layer, (2) covering the non-corroding, conductive layer and those portions of the first layer of passivation not covered with said non-corroding, conductive layer, with a second passivation layer and (3) etching openings in the second passivation layer to allow interconnection of the circuit.

A non-corroding, conductive material is formed on each of the external contacts (bond pads) and areas of the first layer of passivation adjacent to the contacts in a manner which ensures conductivity between the external contact and any point on the non-corroding, conductive material. This process serves two purposes: (1) the non-corroding conductive material seals the external contacts from any degradation which may occur as a result of exposure to the environment and (2) it expands the area over which contact may be made with the external contact. This latter advantage allows for the possibility of "moving" the external contact to form the standardized arrangement described above. As an alternative to this approach, any conductive metal could be used to relocate the bond pads followed by capping at least a portion of this conductive metal with the non-corroding metal.

The non-corroding, conductive materials used herein are known in the art for use within integrated circuits for building the multiple layers of the circuit. The material chosen is not critical and can comprise any which is stable in the environment, electrically conductive and useful for interconnecting the circuit. Examples of such materials include gold, copper, silver, tungsten, solder, silver filled epoxy and the like.

The method for applying this layer is likewise not critical. Examples of such processes include various physical vapor deposition (PVD) techniques such as sputtering and electron beam evaporation or merely dispensing the material in the form of a liquid followed by hardening. These and other processes are also known in the art for use within integrated circuits for building the multiple layers of the circuit and are functional herein. Obviously, if a continuous layer of material is formed on the surface of the circuit, certain portions must be etched to yield discrete areas of material for each external contact. This process is shown in Figures 2 and 3. In Figure 2, a continuous coating of the non-corroding, conductive layer (4) is applied to the chip. Figure 3 shows that layer (4) is etched at area (5) to yield discrete areas for contact.

It should be noted that the materials of the external contact (e.g., aluminum) are often incompatible with the materials of the non-corroding, conductive layer (e.g., gold), such that when they are brought into contact with each other, intermetallic formation ("purple plague") can damage the circuit. To prevent such damage, it is within the scope of this invention to first apply a diffusion barrier metal layer to the external contacts followed by application of the conductive layers as set forth above. The diffusion barrier metal layers useful herein are also known in the art for use within integrated circuits for building the multiple layers of the circuit. Generally, such layers comprise metals and metal alloys such as tungsten, titanium-tungsten, titanium nitride and the like.

The method for forming the barrier metal layers is not critical and many techniques are known in the above art. A common approach involves sputtering the barrier metal layer on the surface of the circuit followed by etching.

After the above non-corroding conductive layer or the barrier metal/non-corroding conductive layers are formed, a second passivation layer is formed on the circuit as shown in Figure 4, layer (6). The materials and methods for forming this layer are the same as those described above for the first layer of passivation. Furthermore, as set forth above, this layer can consist of one or more coatings of such materials.

After the second passivation layer is applied, a portion of this second passivating layer covering the non-corroding, conductive layer is etched to allow for attachment of leads as shown in Figure 5, area (7). The method of etching is as described above for the first layer of passivation. The area for etching is selected such that the resultant area for external contact is one which allows for simplified testing and burn-in as described above. As shown in Figure 5, this area may be adjacent to the original contact or, alternatively, it may be directly above the original contact.

The above processes can be performed at the wafer stage or after dicing. It is preferred herein, however, to perform the processes at the wafer stage for efficiency reasons.

The integrated circuits formed in this manner are hermetically sealed such that their reliability is increased. In addition, the circuits can be handled and manipulated without damage. Furthermore, some of the coatings have the advantage of being opaque to ultraviolet or visible light.

Such circuits are then interconnected with each other, with a lead frame, with a circuit board or other external components. Such interconnection can be by conventional bond wires or by methods such as TAB or "flip chip" processes which are well known in the art.

After interconnection, the device can also be packaged by conventional techniques known in the art. For instance, the device can be embedded within an organic encapsulant such as a polyimide, an epoxy or PARYLENE™, it can be embedded within a silicone encapsulant or it can be included in a plastic package for additional protection.

## Claims

1. A hermetically sealed integrated circuit having a standardized arrangement of external contacts comprising:
a circuit subassembly having external contacts;
a first ceramic passivating layer on the surface of the subassembly with openings for the external contacts;
a non-corroding, conductive layer covering the external contacts and a portion of the first ceramic passivating layer; and
a second ceramic passivating layer covering the non-corroding, conductive layer and that portion of the first passivating layer not covered by the conductive layer;
wherein openings are formed through the second passivating layer to the conductive layer to allow external contact in a standardized arrangement.

2. The circuit of claim 1 wherein both the first and second passivating layers consist of one or more ceramic coatings comprising silicon-containing ceramic materials.

3. The circuit of claim 1 wherein the first passivating layer comprises a silica coating and the second passivating layer comprises a silicon carbide coating.

4. The circuit of claim 1 further characterized by having a first conductive layer positioned between said first ceramic passivating layer and said non-corroding, conductive layer.

5. An integrated circuit having a primary passivation and one or more open external contacts, comprising;
a non-corroding, conductive layer covering the open external contacts and a portion of the passivating layer; and
a ceramic layer covering the non-corroding, conductive layer and that portion of the passivating layer not covered by the conductive layer;
wherein openings are formed through the ceramic layer to the conductive layer to allow external contact.

6. The circuit of claim 5 wherein the ceramic layer consists of one or more ceramic coatings comprising silicon-containing ceramic material.

7. The circuit of claims 1 or 5 wherein the silicon-containing ceramic material is deposited by a chemical vapor deposition technique.

8. The circuit of claims 1 or 5 wherein the silicon-containing ceramic material is deposited by a process comprising applying a coating comprising a preceramic silicon-containing material followed by converting the preceramic material to the silicon-containing ceramic material.

9. The integrated circuit of claims 1 or 5 wherein the non-corroding, conductive layer is made of a material selected from the group consisting of gold, silver, tungsten, solder, silver filled epoxy and copper.

10. The integrated circuit of claims 1 or 5 wherein the ceramic layer is selected from the group consisting of silicon oxides, silicon nitride, silicon oxynitride, silicon oxycarbide, silicon carbonitride, silicon oxycarbonitride and silicon carbide.

11. The integrated circuit of claims 1 or 5 wherein the preceramic silicon-containing material is hydrogen silsesquioxane resin.

12. The integrated circuit of claims 1 or 5 wherein the preceramic silicon-containing material is hydrolyzed or partially hydrolyzed RₙSi(OR)₄₋ₙ, in which each R is independently an aliphatic, alicyclic or aromatic substituent of 1-20 carbon atoms and n is 0-3.

13. The integrated circuit of claims 1 or 5 wherein the preceramic silicon-containing material is hydrolyzed or partially hydrolyzed RₙSi(OR)₄₋ₙ, in which each R is independently an aliphatic, alicyclic or aromatic substituent of 1-4 carbon atoms and n is 0-1.

14. The integrated circuit of claims 1 or 5 wherein the ceramic material is covered by one or more additional ceramic layers selected from the group consisting of SiO₂ coatings, SiO₂/ceramic oxide coatings, silicon coatings, silicon carbon containing coatings, silicon nitrogen containing coatings, silicon oxygen nitrogen containing coatings, silicon carbon nitrogen containing coatings and diamond like carbon coatings.

15. The integrated circuit of claims 1 or 5 which has been interconnected and embedded within a material selected from the group consisting of organic encapsulants and silicone encapsulants.

16. The integrated circuit of claims 1 or 5 wherein the ceramic layers are opaque to ultraviolet or visible light.

17. The integrated circuit of claims 1 or 5 wherein a barrier metal layer is formed between the external contacts and the conductive layer.

18. The integrated circuit of claims 1 or 5 wherein the barrier metal layer is selected from the group consisting of titanium, an alloy of titanium and tungsten and titanium nitride.

19. A method of forming the integrated circuit of claim 1 comprising:
applying a first ceramic passivating layer on the surface of an integrated circuit having external contacts;
removing at least a portion of the first passivating layer covering the external contacts;
applying a non-corroding, conductive layer over the external contacts and a portion of the first ceramic passivating layer;
applying a second ceramic passivating layer over the non-corroding, conductive layer and that portion of the first passivating layer not covered by the conducting layer; and
removing at least a portion of the second passivating layer covering the conducting layer to allow external contact.

20. A method for hermetically sealing the integrated circuit of claim 5 having a primary passivation and one or more open external contacts, the method comprising:
applying a non-corroding, conductive layer over the open external contacts and a portion of the primary passivation;
applying a ceramic layer over the non-corroding, conductive layer and that portion of the passivating layer not covered by the conducting layer; and
removing at least a portion of the ceramic layer covering the conducting layer to allow external contact.
